# FASCICULE DE BREVET EUROPEEN

(11) **EP 0 455 570 B1**
(45) Date de publication et mention de la délivrance du brevet: **02.10.1996**
(21) Numéro de dépôt: 91460027.5
(22) Date de dépôt: 03.05.1991
(51) Int. Cl.: H03F 1/48, H03F 3/08, H03F 3/193

(54) **Dispositif d'amplification très large bande continu-hyperfréquences, notamment réalisable en circuit intégré**
Sehr breitbandige Verstärkungseinrichtung für Gleichstrom bis Mikrowellen, insbesondere geeignet für integrierte Schaltungen
Very wide bandwidth amplifier device for DC to microwave frequencies, particularly in the form of an integrated circuit

(30) Priorité: 03.05.1990 FR 9005855
(43) Date de publication de la demande: 06.11.1991
(73) Titulaire: FRANCE TELECOM, 75015 Paris (FR)
(72) Inventeur: Soares, Robert, F-22700 Perros-Guirrec (FR); Mottet, Serge, F-22650 Trebeurden (FR); Follot, Georges, F-22140 Pluzunet (FR); Perennec, André, F-29200 Brest (FR)
(74) Mandataire: Corlau, Vincent

(56) Documents cités:
- EP-A- 0 318 379
- DE-A- 2 846 687
- ELECTRONICS LETTERS, vol. 25, no. 19, 14 septembre 1989, Enage, GB, pages 1305-1306; Y. MIYAGAWA et al.: "7 Ghz Bandwidth Optical Front-end Circuit using GaAs FET Monolithic ICTechnology"
- IEEE TRANSACTIONS ON MICROWAVE THEORY AND TECHNIQUES, vol. MTT35, no. 10, octobre 1987, New York, US, pages 923-925; M. SHIGAKI et al.: "GaAs Monolithic DC-6,4-GHz Variable-gain Feedback Amplifier"

## Description

Le domaine de l'invention est celui de l'amplification de signaux électriques très large bande, du continu aux hyperfréquences, et plus précisément du continu jusqu'à des fréquences microondes supérieures à 6 GHz.

Une application privilégiée de l'invention est l'amplification de signaux transmis par des systèmes de transmission à très haut débit, notamment en fibre optique monomode.

En effet, l'augmentation rapide du trafic dans les systèmes de transmission ces dernières années a favorisé le développement des systèmes optiques de transmission monomode à très haut débit. Les répéteurs optiques réalisés pour de tels systèmes requièrent la mise en place de circuits électroniques rapides pour la modulation à l'émission et pour la démodulation à la réception. Dans ces répéteurs, ou têtes optiques, des amplificateurs très large bande sont nécessaires à la modulation de la diode laser d'émission et à la démodulation de la photodiode de réception.

L'invention peut également être utilisée en instrumentation, par exemple pour la réalisation d'amplificateurs pour impulsions rapides ou échelons à temps de montée court, ainsi que pour des applications militaires, notamment dans le domaine des amplificateurs vidéo, des applications médicales, et plus généralement dans tous les domaines où il est nécessaire d'amplifier sur une très large bande de fréquences.

Il est connu que les éléments actifs utilisés à la construction des amplificateurs à deux accès (transistors) présentent la particularité d'avoir besoin de polarisations continues différentes à chaque accès.

Il devient donc nécessaire dans un amplificateur à plusieurs étages d'amplification d'utiliser soit des condensateurs de forte valeur, pour laisser passer les fréquences basses, soit des topologies d'amplificateur continu, pour permettre la polarisation indépendante de chaque étage d'amplification.

On connaît par exemple des amplificateurs à condensateur intra-étage tels que les amplificateurs SHF 74 et SHF 74P, commercialisés par la société SHF-DESIGN BERLIN (marque déposée). Dans de tels amplificateurs, les condensateurs utilisés ont une valeur de 10 nF. Leur réalisation ne peut donc être faite qu'en technologie hybride.

La très large bande de fréquences est obtenue en utilisant une boucle de contre-réaction à chaque étage, avec un condensateur de 50 pF dans la boucle, afin de pouvoir maintenir des polarisations en continu différentes à chaque accès de transistor. De tels amplificateurs ont un gain plat d'environ 2 dB dans une bande de 500 KHz à 8 GHz.

Outre les problèmes de mise en oeuvre, obligeant l'utilisation de circuits hybrides, les amplificateurs à condensateur sont confrontés à l'impossibilité, de par le principe même du condensateur, d'amplifier les fréquences basses (entre 0 et 500 KHz dans cet exemple).

L'utilisation des condensateurs peut être évitée dans des amplificateurs continus réalisés en technologie circuit intégré microondes monolithique (MMIC), tels que ceux décrits par Colleran, W.T. et A.A.Abidi, dans "A 3.2 GHz, 26 dB wide-band monolithic matched GaAs MESFET feedback amplifier using Cascodes". (Un amplificateur GaAs MESFET monolithique large bande à contre-réaction, 3,2 GHz, 26 dB, utilisant des transistors en topologie cascode) (IEEE Trans. Microwave Theory Tech., vol. MTT-36, pp. 1377-1385, October 1988).

Ces amplificateurs comprennent une série d'étages d'amplification à base de transistors à effet de champ en arséniure de gallium (GaAs MESFET). L'indépendance de polarisation entre le drain du transistor actif d'un étage et la grille du transistor actif de l'étage suivant est assurée par deux transistors et un pont à diodes. Des amplificateurs de ce type réalisés en technologie MMIC à base de transistors GaAs MESFET de longueur de grille de 1 µm sont limités en haute fréquence à moins de 3.5 GHz. L'utilisation d'une technologie à base de transistors de 0,5 µm de grille permet d'étendre cette limite supérieure à 5 GHz.

Certaines améliorations de cette technique, permettant d'augmenter sensiblement le rendement, sont connues. Ainsi, par exemple, il est possible de disposer une capacité en parallèle sur le pont à diodes, tel que cela est décrit dans l'article "7 GHz bandwidth optical front-end circuit using GaAs FET monolithic IC technology" ("circuit frontal pour transmission optique utilisant la technologie des circuits intégrés monolithiques à transistors à effet de champ GaAs") de Miyagawa et al. (Electronics Letters, vol.25, n°19, 14 septembre 1989, pp.1305-1306).

Il est également possible d'augmenter la bande de fréquence d'un tel amplificateur d'environ 25 %, en utilisant des transistors montés en topologie cascode.

L'utilisation de transistors pour séparer les étages d'amplification s'avère très efficace en ce qui concerne l'isolation en continu entre les étages. En revanche, ces transistors coupent très vite en hautes fréquences. De plus, il se pose rapidement des problèmes de résonance. De tels amplificateurs restent donc limités dans les hyperfréquences, du fait de leur principe de base.

Le document de brevet DE-A-2 846 687 décrit un dispositif d'amplification, le plus proche de celui de l'invention, comprenant un transistor d'amplification monté en source commune et associé à un autre transistor jouant un rôle de contre-réaction. Le drain du transistor d'amplification est polarisé par une charge saturable constituée par un transistor. Le découplage du continu entre l'entrée et la sortie est réalisé par un pont à diodes polarisé en direct et alimenté par deux transistors. Ainsi, les basses fréquences peuvent passer, sans qu'un condensateur soit utilisé. Par ailleurs, la séparation des étages ne nécessite pas de transistor devant être associé au pont à diodes.

Une autre façon de réaliser un amplificateur très large bande est proposée par Kahlert, J., W. Piscalar et N. Mulombe dans "DC-12.3 GHz broadband amplifier",(amplificateur large bande continu-12,3 GHz) (El. Lett., vol.25, n°.21, pp.1463-1465, 12 oct. 1989). Il s'agit d'amplificateurs à duplexage spectral, dans lesquels les fréquences inférieures et les fréquences supérieures sont séparées par un réseau composé de condensateurs et de résistances. La partie du signal composée de hautes fréquences est amplifiée normalement en hyperfréquences, et la composante à basses fréquences est amplifiée par une série d'amplificateurs opérationnels avant d'être réinjectée sur la grille du transistor d'amplification. Le réseau à amplificateurs opérationnels sert également à polariser ce transistor. Un amplificateur à deux étages ainsi réalisé en circuit hybride permet d'obtenir un gain de 10 dB ± 1,5 dB du continu à 12,3 GHz.

Les amplificateurs à duplexage spectral ne peuvent être réalisés qu'en technologie hybride. Par ailleurs, ils sont de conception relativement complexe, et comprennent un nombre important de composants de base.

L'invention a pour objectifs de pallier ces différents inconvénients de l'état de la technique.

Plus précisément, un objectif essentiel de l'invention est de fournir un dispositif d'amplification très large bande, du continu à des fréquences supérieures à 6 GHz, notamment applicable à la transmission sur fibre optique monomode. L'invention a ainsi notamment pour objectif de fournir un tel dispositif non limité en performance en hyperfréquences par les composants et l'architecture utilisés.

Un autre objectif de l'invention est de fournir un tel dispositif d'amplification aisément réalisable en circuit intégré, et notamment en circuit intégré microonde monolithique (MMIC).

Un objectif particulier de l'invention est de fournir un dispositif d'amplification continu microondes ne nécessitant pas l'utilisation de condensateurs de forte valeur, ou de tout autre composant imposant une réalisation en circuit hybride.

Un autre objectif de l'invention est de fournir un tel dispositif d'amplification n'utilisant pas de transistors pour assurer le décalage en tension entre deux étages d'amplification consécutifs, ceux-ci limitant les performances des amplificateurs dans le domaine des hautes fréquences.

L'invention a également pour objectif de fournir un tel dispositif d'amplification de coût de revient faible, c'est-à-dire à nombre réduit de composants, et notamment de composants actifs.

Un autre objectif important de l'invention est de limiter les différents phénomè nes de perturbations micro-ondes qui peuvent apparaître dans de tels dispositifs d'amplification. Notamment, l'invention vise à éviter l'utilisation de transistors pour assurer l'isolation entre deux étages d'amplification.

L'invention a également pour objectif de fournir un dispositif d'amplification à gain d'amplification élevé.

Ces objectifs, ainsi que d'autres qui apparaîtront par la suite, sont atteints à l'aide du dispositif faisant l'objet de la revendication 1.

Avantageusement, lesdits moyens de maintien d'une polarisation de tension continue positive sur le drain dudit transistor d'amplification sont constitués d'un transistor à effet de champ opérant en charge saturable, la grille étant reliée à la source, et le drain étant alimenté à partir d'une source de tension positive.

Dans un mode de réalisation préférentiel de l'invention, lesdits moyens de maintien d'une polarisation de tension continue négative ou nulle sur la grille dudit transistor d'amplification comprend une résistance, reliant ladite grille à la masse. La tension de polarisation est alors nulle. Une tension négative de polarisation, permettant d'augmenter la sensibilité de l'amplificateur, peut par exemple être obtenue en ajoutant une seconde résistance, reliant la grille dudit transistor d'amplification à une source de tension négative.

Dans un autre mode de réalisation avantageux de l'invention, lesdits moyens de maintien d'une polarisation de tension continue négative ou nulle sur la grille dudit transistor d'amplification comprennent une première résistance reliant ladite grille à une source de tension positive et une seconde résistance reliant ladite grille à une source de tension négative.

De façon avantageuse, ledit transistor opérant en charge saturable a un développement de grille suffisant pour permettre l'alimentation simultanée en courant continu dudit transistor d'amplification et dudit pont à diodes au-dessus du courant de seuil.

Il est à noter que ce transistor n'est utilisé que pour l'alimentation en courant du transistor d'amplification et du pont à diodes, et qu'il n'intervient pas dans la fonction de décalage en tension entre deux étages d'amplification. Ce rôle est joué par le seul pont à diodes. Ainsi, il n'y a aucune limitation intrinsèque (due au transistor) de la performance en hyperfréquence de l'amplificateur.

Préférentiellement, le dispositif d'amplification comprend des moyens de maintien d'un courant constant et supérieur au courant de seuil dans ledit pont à diodes.

Dans un mode de réalisation particulier de l'invention, lesdits moyens de maintien d'un courant constant sont constitués d'un transistor à effet de champ opérant en charge saturable, la grille étant reliée à la source, et alimenté à partir d'une source de tension négative.

Avantageusement, un condensateur est placé en parallèle avec ledit pont à diodes, de façon à compenser les pertes en hautes fréquences.

De façon préférentielle, le dispositif d'amplification comprend une résistance de contre-réaction, placée entre la grille dudit transistor d'amplification et la sortie dudit étage d'amplification.

Le dispositif de l'invention peut également comprendre au moins un réseau d'adaptation sans perte, placé en entrée dudit étage d'amplification et/ou en sortie dudit transistor d'amplification.

De façon avantageuse, lesdits réseaux d'adaptation sont des éléments localisés et/ou des éléments distribués en microruban.

Dans un mode de réalisation particulier de l'invention, lesdits transistors à effet de champ sont des transistors en arséniure de gallium. Ils peuvent également avantageusement être des transistors à hétérojonction à haute mobilité d'électrons.

Le dispositif d'amplification de l'invention peut être de façon avantageuse implanté dans un circuit intégré micro-ondes monolithique.

D'autres caractéristiques et avantages de l'invention apparaîtront à la lecture de la description suivante d'un mode de réalisation préférentiel du dispositif de l'invention, donné à titre illustratif et non limitatif, et des dessins annexés dans lesquels :
- la figure 1 est le schéma de principe d'une tête de réception optique comprenant deux amplificateurs ;
- la figure 2 présente le schéma électrique d'un étage d'un dispositif d'amplification selon l'invention, tel qu'utilisé dans la tête de réception optique de la figure 1 ;
- la figure 3 est un exemple de topographie sur circuit intégré d'un dispositif d'amplification à quatre étages tels que présentés en figure 2.

Le mode de réalisation particulier décrit ci-dessous s'applique notamment à la réception de signaux transmis à très haut débit en fibre optique monomode. Il est clair toutefois que le dispositif de l'invention trouve de nombreuses applications dans d'autres domaines, et notamment chaque fois qu'il est nécessaire d'amplifier sur une très large bande de fréquences, pouvant aller du continu aux hyperfréquences.

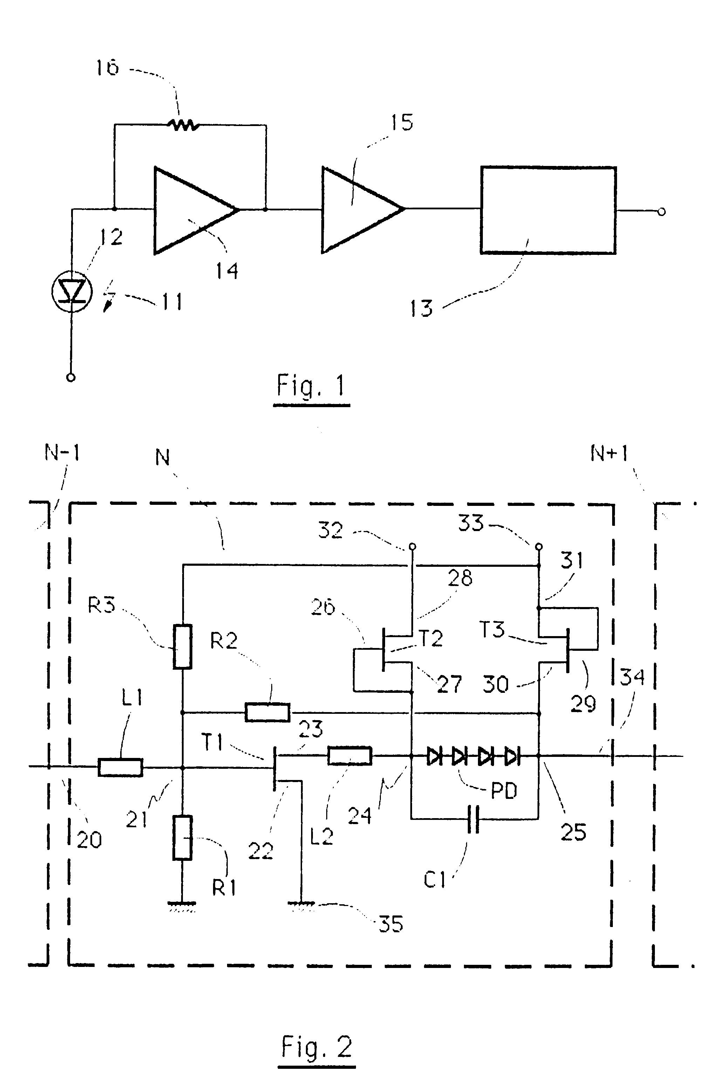

La figure 1 présente le schéma de principe d'une tête de réception optique. De façon classique, les signaux 11 transmis sont reçus par une photodiode 12.

Ces signaux sont transmis au module 13 de démodulation, par l'intermédiaire de deux amplificateurs 14 et 15.

Le premier amplificateur 14 est un amplificateur transimpédance, comprenant une résistance 16 en parallèle. Son objectif essentiel est de réaliser une adaptation d'impédance entre la photodiode 12 et les circuits suivants 15, 13. En effet, une photodiode a une impédance dont la partie résistive est quasi infinie, alors que les circuits d'amplification 15 et de démodulation 13 fonctionnent classiquement avec une résistance d'entrée de l'ordre de 50 Ω.

Dans le domaine optique, on vise le double objectif d'obtenir une bande de fréquences la plus large possible, avec un bruit le plus faible possible. L'amplificateur transimpédance 14, ou pré-amplificateur doit donc réaliser le meilleur compromis entre l'amortissement (minimal) et la largeur de bande (maximale). Avantageusement, il permet également d'obtenir un peu de gain d'amplification.

Le second amplificateur 15, ou post-amplificateur, a pour but d'amplifier le signal avant la démodulation 13. Il a par exemple une impédance d'entrée et de sortie d'environ 50 Ω.

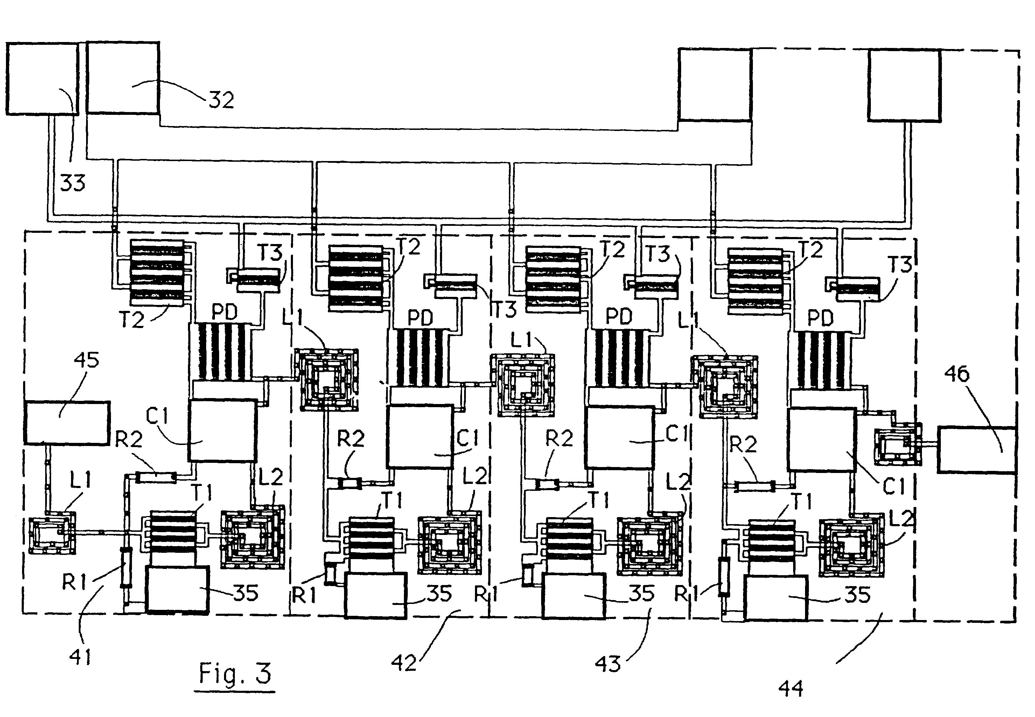

Les deux amplificateurs 14 et 15 peuvent avantageusement être réalisés selon la topologie de l'invention. Cela permet en effet de ne pas rencontrer de problèmes de limitation dans les hyperfréquences. L'exemple de réalisation présenté en figure 3 correspond plus précisément au post-amplificateur 15.

La figure 2 est le schéma électrique d'un mode de réalisation particulier d'un étage N d'amplification selon l'invention.

L'élément actif d'amplification de cet étage est un transistor T1 à effet de champ (FET) monté en source commune. La source 22 de ce transistor T1 est reliée à la masse 35 du circuit. Le signal à amplifier 20 est injecté sur la grille 21 de T1, et le signal amplifié est obtenu sur le drain 23 de ce transistor T1.

Le dispositif comprend des moyens de maintien simultané des polarisations de tension positive sur le drain 23 et de tension nulle sur la grille 21 du transistor en source commune T1.

Une tension de grille nulle peut être assurée à chaque étage par une unique résistance R1 qui relie la grille 21 de cet étage à la masse 35.

Dans un autre mode de réalisation, la tension de grille peut être maintenue négative. En effet, une tension grille-source négative permet d'augmenter la sensibilité de l'amplificateur. On utilise pour cela un pont de résistances R1, R3, R1 étant reliée à la masse et R3 à une source de tension négative V_{SS} 33. Le rapport des valeurs des résistances R1 et R3 permet d'obtenir, en fonction de la source de tension V_{SS} 33, la tension négative souhaitée sur la grille 21 du transistor T1.

Selon un autre mode de réalisation, cette tension négative peut également être obtenue à l'aide d'un pont de résistances reliées, pour la première, à la source de tension positive V_{DS} 32, et pour la seconde, à la source de tension négative V_{SS} 33.

Le drain du transistor T1 est alimenté en tension V_{DS} par l'intermédiaire d'un transistor à effet de champ T2, opérant en charge saturable. La grille 26 de ce transistor T2 est reliée à la source 27, elle même connectée au noeud 24, correspondant, en ce qui concerne le fonctionnement en continu, au drain 23 du transistor T1. Le drain 28 du transistor T2 est relié à une source de tension continue positive V_{DD} 32.

Dans un tel dispositif à plusieurs étages d'amplification N-1, N, N+1, il est nécessaire d'abaisser la tension continue en sortie de chaque étage N, de façon à ramener une tension continue négative ou nulle en entrée de l'étage N+1.

Selon l'art antérieur, cette fonction de décalage en tension est par exemple assurée par un ou plusieurs transistors et un pont à diodes. Cette solution présente l'avantage d'être aisée à mettre en oeuvre, et d'assurer une bonne isolation en continu entre les étages. En revanche, elle entraîne une limitation des performances de l'amplificateur, dans le domaine des hautes fréquences. En effet, les transistors coupent très vite dans les hautes fréquences, et il apparaît des problèmes de résonance. Ainsi, ce type de montage est limité à 3 ou 4 GHz, selon sa complexité et la performance en hyperfréquence des transistors utilisés.

Dans le dispositif de l'invention, la fonction de décalage est assurée par un seul pont à diodes PD, reliant la sortie 24 de l'élément d'amplification T1 à la sortie 25 de l'étage N d'amplification. Dans ce cas, il n'y a pas de limitation intrinsèque à la performance en hyperfréquence de l'amplificateur, du fait qu'aucun transistor n'est utilisé pour séparer les étages d'amplification.

Le nombre et la taille des diodes du pont à diodes PD sont choisis en fonction des besoins en alimentation continue (courant et tension de drain) du transistor T1 en source commune. La chute de tension à travers le pont à diodes PD est égale à la tension entre drain 23 et source 22 du transistor T1. Dans le mode de réalisation présenté, la source 22 étant reliée à la masse 35, cette chute de tension est égale à la tension entre le drain 23 et la masse. On ramène ainsi une tension nulle entre la sortie 25 de l'étage N d'amplification et la masse 35.

Le courant de seuil circulant dans ce pont à diodes PD est maintenu constant par un transistor T3, dont la grille 29 est rattachée à la source 31 afin de créer une charge saturable. Ce transistor T3 est alimenté sur sa source 31 à partir d'une source de tension négative V_{SS} 33, afin d'assurer un courant suffisant dans le pont à diodes PD pour maintenir la tension continue nulle à la sortie 25 de l'étage N auquel est relié le drain 30.

Un condensateur C1 est placé en parallèle avec le pont à diodes PD, entre la sortie 24 de l'élément d'amplification T1 et la sortie 25 de l'étage N d'amplification. Ceci permet de compenser les pertes en hautes fréquences dues au pont à diodes PD.

Une résistance de contre-réaction R2, placée entre l'entrée 21 et la sortie 25 de l'étage d'amplification, permet de réaliser la performance dynamique du dispositif, sans nuire aux conditions de polarisation statique. Cette résistance R2 a notamment pour but de faciliter l'adaptation du transistor T1, et d'obtenir ainsi la bande de fréquences la plus large possible. Par ailleurs, elle permet également d'assurer la stabilité du dispositif, et un gain d'amplification plat.

Des réseaux d'adaptation à éléments sans pertes L1, L2 à chaque étage permettent, avec les résistances R1 et R2, de faire l'adaptation très large bande du transistor. Ces réseaux peuvent être réalisés soit avec des éléments localisés, soit avec des éléments distribués en microruban, soit avec un mélange des deux.

Le premier réseau d'adaptation L1 est placé entre l'entrée 20 de chaque étage d'amplification et la grille 21 du transistor T1. Le second réseau L2 est relié d'une part au drain 23 du transistor T1 et, d'autre part, au noeud 24, correspondant à l'entrée du pont à diodes PD et à la source 27 du transistor T2.

Un tel dispositif peut avantageusement comprendre plusieurs étages d'amplification N-1, N, N+1, similaires à celui décrit.

On précise ci-dessous une façon de déterminer la taille des différents transistors T1, T2 et T3, et des diodes du pont à diodes PD.

La première étape est le choix du développement de grille du transistor T1, en fonction de considérations hyperfréquences (gain, bruit, adaptation). On établit ainsi le courant drain-source I_{DS} du transistor T1.

La taille, c'est-à-dire le développement de l'anode, des diodes dans le pont à diodes PD est ensuite choisie en fonction d'un compromis entre les pertes en courant alternatif et la consommation en courant continu I_{PD} dans le pont à diodes PD. La taille des diodes peut par exemple être choisie de façon que le courant I_{PD} soit inférieur ou égal à I_{DS}/6. Il est clair que, par ailleurs, I_{PD} doit être supérieur ou égal au courant de seuil des diodes.

La taille de la grille du transistor T3, qui opére comme une charge saturable, est ensuite choisie afin de maintenir le courant I_{PD} dans le pont à diodes.

Enfin, la taille de la grille transistor T2 est choisie telle que le courant fourni I_{DD} soit égal à I_{DS} + I_{PD}.

Le drain de la charge saturable T2 est alimenté à partir d'une source de tension positive V_{DD}, choisie de manière à maintenir la tension drain-source, V_{DS}, aux bornes du transistor T1 nécessaire pour assurer son fonctionnement optimal en amplification.

De même, la source de la charge saturable T3 est alimentée à partir d'une source de tension négative V_{SS}, choisie de manière à maintenir une tension nulle entre le noeud 25 et la masse 35.

La figure 3 présente un exemple de topographie sur circuit intégré d'un tel dispositif d'amplification à quatre étages 41, 42, 43 et 44, réalisé en technologie circuit intégré microondes monolithique (MMIC) à base de transistors à effet de champ en arséniure de gallium (GaAs MESFET). Ce circuit suit les règles de la fonderie GaAs MESFET MMIC ANADIGICS (marque déposée).

Le signal à amplifier est introduit sur le plot d'entrée 45, et successivement amplifié par les quatre étages d'amplification 41, 42, 43 et 44. Le signal amplifié est récupéré sur le plot de sortie 46. Chaque étage d'amplification est, dans son principe, identique à celui du schéma électrique de la figure 2. On notera toutefois que la tension continue de drain du transistor T1 est maintenue nulle, du fait qu'il n'y a pas de pont de résistances R1, R3, mais une seule résistance R1 reliée à la masse 35.

Ce dispositif d'amplification à quatre étages permet d'obtenir un gain du continu à 10 GHz de 22 dB ± 1,5 dB.

Il est bien sûr possible de réaliser le dispositif de l'invention selon d'autres technologies, et par exemple à l'aide de transistors à haute mobilité d'électrons.

## Revendications

1. Dispositif d'amplification très large bande continu-hyperfréquences, notamment pour l'amplification de signaux transmis à très haut débit sur fibre optique, du type comprenant au moins un étage (N-1, N, N+1) d'amplification dont l'élément actif d'amplification est un transistor (T1) à effet de champ monté en source commune, chaque étage (N-1, N, N+1) d'amplification comprenant :
- des moyens de maintien d'une polarisation de tension continue positive sur le drain (23) dudit transistor (T1) ; et
- des moyens de maintien d'une tension continue négative ou nulle en sortie (25) dudit étage d'amplification, comprenant un pont à diodes (PD) assurant une chute de tension entre le drain (23) dudit transistor (T1) et ladite sortie (25) de l'étage d'amplification ;
caractérisé en ce que chaque étage (N-1, N, N+1) d'amplification comprend :
- des moyens de maintien d'une polarisation de tension continue négative ou nulle sur la grille (21) dudit transistor (T1) ; et
- une résistance de contre-réaction (R2), placée entre la grille (21) dudit transistor (T1) et la sortie (25) dudit étage d'amplification.

2. Dispositif selon la revendication 1, caractérisé en ce que lesdits moyens de maintien d'une polarisation de tension continue positive sur le drain (23) dudit transistor (T1) sont constitués d'un transistor (T2) à effet de champ opérant en charge saturable, la grille (26) étant reliée à la source (27), et le drain (28) étant alimenté à partir d'une source de tension positive (32).

3. Dispositif selon l'une quelconque des revendications 1 ou 2, caractérisé en ce que lesdits moyens de maintien d'une polarisation de tension continue négative ou nulle sur la grille (21) dudit transistor (T1) comprennent une résistance (R1), reliant ladite grille (21) à la masse (35).

4. Dispositif selon la revendication 3, caractérisé en ce que lesdits moyens de maintien d'une polarisation de tension continue négative ou nulle sur la grille (21) dudit transistor (T1) comprennent également une résistance (R3), reliant ladite grille (21) à une source de tension négative (33).

5. Dispositif selon l'une quelconque des revendications 1 ou 2, caractérisé en ce que lesdits moyens de maintien d'une polarisation de tension continue ou nulle sur la grille (21) dudit transistor d'amplification (T1) comprennent une première résistance reliant ladite grille (21) à une source de tension positive (32) et une seconde résistance reliant ladite grille (21) à une source de tension négative (33).

6. Dispositif selon l'une quelconque des revendications 2 à 5, caractérisé en ce que ledit transistor (T2) a un développement de grille suffisant pour permettre l'alimentation simultanée en courant continu dudit transistor (T1) et dudit pont à diodes (PD) au-dessus du courant de seuil.

7. Dispositif selon l'une quelconque des revendications 1 à 6, caractérisé en ce qu'il comprend des moyens de maintien d'un courant constant et supérieur au courant de seuil dans ledit pont à diodes (PD).

8. Dispositif selon la revendication 7, caractérisé en ce que lesdits moyens de maintien d'un courant constant sont constitués d'un transistor (T3) à effet de champ opérant en charge saturable, la grille (29) étant reliée à la source (31), et alimenté à partir d'une source de tension négative (33).

9. Dispositif selon l'une quelconque des revendications 6 à 8, caractérisé en ce qu'un condensateur (C1) est placé en parallèle avec ledit pont à diodes (PD), de façon à compenser les pertes en hautes fréquences.

10. Dispositif selon l'une quelconque des revendications 1 à 9, caractérisé en ce qu'il comprend au moins un réseau d'adaptation sans perte (L1, L2), placé en entrée (L1) dudit étage d'amplification et/ou en sortie (L2) dudit transistor d'amplification (T1).

11. Dispositif selon la revendication 10, caractérisé en ce que lesdits réseaux d'adaptation (L1, L2) sont des éléments localisés et/ou des éléments distribués en microruban.

12. Dispositif selon l'une quelconque des revendications 1 à 11, caractérisé en ce que lesdits transistors (T1, T2, T3) à effet de champ sont des transistors en arséniure de gallium ou des transistors à hétérojonction à haute mobilité d'électrons.

13. Dispositif selon l'une quelconque des revendications 1 à 12, caractérisé en ce qu'il est implanté dans un circuit intégré micro-ondes monolithique.

## Patentansprüche

1. Extremer kontinuierlicher Hyperfrequenzen-Breitbandverstärker, insbesondere zum Verstärken von Signalen, die mit sehr hohem Durchsatz über optische Fasern gesendet werden, mit mindestens einer Verstärkerstufe (N-1, N, N+1), deren aktives Verstärkerelement aus einem Feldeffekttransistor (T1) in gemeinsamer Sourceschaltung besteht, wobei jede Verstärkerstufe (N-1, N, N+1) folgendes umfaßt:
- Mittel zum Aufrechterhalten der Polarisierung einer positiven Gleichspannung am Drain-Anschluß (23) des Transistors (T1) sowie
- Mittel zum Aufrechterhalten einer negativen Gleichspannung oder einer Nullspannung am Ausgang (25) der Verstärkerstufe, die eine Diodenbrücke (PD) umfaßt, welche einen Spannungsabfall zwischen dem Drain-Anschluß (23) des Transistors (T1) und dem Ausgang (25) der Verstärkerstufe sicherstellt;
dadurch gekennzeichnet, daß jede Verstärkerstufe (N-1, N, N+1) folgendes umfaßt:
- Mittel zum Aufrechterhalten der Polarisierung einer negativen Gleichspannung oder einer Nullspannung am Gate (21) des Transistors (T1) und
- einen Gegenreaktionswiderstand (R2), der sich zwischen dem Gate (21) des Transistors (T1) und dem Ausgang (25) der Verstärkerstufe befindet.

2. Vorrichtung gemäß Anspruch 1,
dadurch gekennzeichnet, daß die Mittel zum Aufrechterhalten der Polarisierung einer positiven Gleichspannung am Drain-Anschluß (21) des Transistors (21) aus einem Feldeffekttransistor (T2) bestehen, der im Sättigungszustand arbeitet, wobei das Gate (26) mit dem Source (27) verbunden ist und der Drain-Anschluß (28) aus einer positiven Spannungsquelle (32) versorgt wird.

3. Vorrichtung gemäß einem der Ansprüche 1 oder 2,
dadurch gekennzeichnet, daß die Mittel zum Aufrechterhalten der Polarisierung einer negativen Gleichspannung oder einer Nullspannung am Gate (21) des Transistors (T1) einen Widerstand (R1) umfassen, der das Gate (21) mit der Masse (35) verbindet.

4. Vorrichtung gemäß Anspruch 3,
dadurch gekennzeichnet, daß die Mittel zum Aufrechterhalten der Polarisierung einer negativen Gleichsspannung oder einer Nullspannung am Gate (21) des Transistors (T1) ebenfalls einen Widerstand (R3) umfassen, der das Gate (21) mit einer negativen Spannungsquelle (33) verbindet.

5. Vorrichtung gemäß einem der Ansprüche 1 oder 2,
dadurch gekennzeichnet, daß die Mittel zum Aufrechterhalten der Polarisierung einer negativen Gleichspannung oder einer Nullspannung am Gate (21) des Verstärkertransistors (T1) einen ersten Widerstand umfassen, der das Gate (21) mit einer positiven Spannungsquelle (32) verbindet sowie einen zweiten Widerstand, der das Gate (21) mit einer negativen Spannungsquelle (33) verbindet.

6. Vorrichtung gemäß einem der Ansprüche 2 bis 5,
dadurch gekennzeichnet, daß der Transistor (T2) eine ausreichende Gatewirkung hat, um die gleichzeitige Versorgung des Transistors (T1) und der Diodenbrücke (PD) oberhalb des Schwellenstroms mit Gleichstrom zu gewährleisten.

7. Vorrichtung gemäß einem der Ansprüche 1 bis 6,
dadurch gekennzeichnet, daß sie Mittel zum Aufrechterhalten eines konstanten Stroms in der Diodenbrücke (PD) umfaßt, der höher als der Schwellenstrom ist.

8. Vorrichtung gemäß Anspruch 7,
dadurch gekennzeichnet, daß die Mittel zum Aufrechterhalten eines konstanten Stroms aus einem Feldeffekttransistor (T3) bestehen, der in Sättigungszustand arbeitet, wobei das Gate (29) mit dem Source (31) verbunden ist und aus einer negativen Spannungsquelle (33) versorgt wird.

9. Vorrichtung gemäß einem der Ansprüche 6 bis 8,
dadurch gekennzeichnet, daß ein Kondensator (C1) parallel zur Diodenbrücke (PD) geschaltet ist, um die Hochfrequenzverluste auszugleichen.

10. Vorrichtung gemäß einem der Ansprüche 1 bis 9,
dadurch gekennzeichnet, daß sie mindestens ein verlustfreies Anpassungsnetz (L1, L2) umfaßt, das am Eingang (L1) der Verstärkerstufe und/oder am Ausgang (L2) des Verstärkertransistors (T1) angebracht ist.

11. Vorrichtung gemäß Anspruch 10,
dadurch gekennzeichnet, daß es sich bei den Anpassungsnetzen (L1, L2) um örtliche Elemente und/oder um verteilte Elemente handelt, die in Streifenleitertechnik verteilt sind.

12. Vorrichtung gemäß einem der Ansprüche 1 bis 11,
dadurch gekennzeichnet, daß es sich bei den Feldeffekttransistoren (T1, T2, T3) um Galliumarsenid-Transistoren oder um Hetero-Junction-Transistoren mit hoher Elektronenbeweglichkeit handelt.

13. Vorrichtung gemäß einem der Ansprüche 1 bis 12,
dadurch gekennzeichnet, daß sie innerhalb einer integrierten monolithischen Mikrowellenschaltung eingebaut ist.

## Claims

1. Ultra-wideband dc-UHF amplification device, in particular for the amplification of signals transmitted at very high bit rates on optical fibres, of the type including at least one amplification stage (N-1, N, N+1), the active amplification element of which is a field-effect transistor (T1) mounted in common source mode, each amplification stage (N-1, N, N+1) including:
- means for maintaining a positive dc voltage bias on the drain (23) of the said transistor (T1); and
- means for maintaining a negative or zero dc voltage at the output (25) of the said amplification stage, including a diode bridge (PD) providing a voltage drop between the drain (23) of the said transistor (T1) and the said output (25) of the amplification stage;
characterized in that each amplification stage (N-1, N, N+1) includes:
- means for maintaining a negative or zero dc voltage bias on the gate (21) of the said transistor (T1); and
- a feedback resistor (R2) placed between the gate (21) of the said transistor (T1) and the output (25) of the said amplification stage.

2. Device according to Claim 1, characterized in that the said means for maintaining a positive dc voltage bias on the drain (23) of the said transistor (T1) are constituted by a field-effect transistor (T2) working in saturable load mode, the gate (26) being connected to the source (27), and the drain (28) being supplied from a positive voltage source (32).

3. Device according to either one of Claims 1 and 2, characterized in that the said means for maintaining a negative or zero dc voltage bias on the gate (21) of the said transistor (T1) include a resistor (R1) connecting the said gate (21) to earth (35).

4. Device according to Claim 3, characterized in that the said means for maintaining a negative or zero dc voltage bias on the gate (21) of the said transistor (T1) also include a resistor (R3) connecting the said gate (21) to a negative voltage source (33).

5. Device according to either one of Claims 1 and 2, characterized in that the said means for maintaining a negative or zero dc voltage bias on the gate (21) of the said amplification transistor (T1) include a first resistor connecting the said gate (21) to a positive voltage source (32) and a second resistor connecting the said gate (21) to a negative voltage source (33).

6. Devi.ce according to any one of Claims 2 to 5, characterized in that the said transistor (T2) has a gate spread sufficient to enable the simultaneous dc supply of the said transistor (T1) and of the said diode bridge (PD) above the threshold current.

7. Device according to any one of Claims 1 to 6, characterized in that it includes means for maintaining a constant current greater than the threshold current in the said diode bridge (PD).

8. Device according to Claim 7, characterized in that the said means for maintaining a constant current are constituted by a field-effect transistor (T3) working in saturable load mode, the gate (29) being connected to the source (31), and being supplied from a negative voltage source (33).

9. Device according to any one of Claims 6 to 8, characterized in that a capacitor (C1) is placed in parallel with the said diode bridge (PD), so as to compensate for the losses at high frequencies.

10. Device according to any one of Claims 1 to 9, characterized in that it includes at least one no-loss matching network (L1, L2) placed at the input (L1) of the said amplification stage and/or at the output (L2) of the said amplification transistor (T1).

11. Device according to Claim 10, characterized in that the said matching networks (L1, L2) are localized elements and/or microstrip distributed elements.

12. Device according to any one of Claims 1 to 11, characterized in that the said field-effect transistors (T1, T2, T3) are gallium arsenide transistors or heterojunction transistors with high electron mobility.

13. Device according to any one of Claims 1 to 12, characterized in that it is fitted into a monolithic UHF integrated circuit.
